Europäisches Patentamt

(19) European Patent Office — (11) Veröffentlichungsnummer: **0 138 061**

Office européen des brevets — **B1**

(12) **EUROPÄISCHE PATENTSCHRIFT**

(45) Veröffentlichungstag der Patentschrift:
29.06.88

(21) Anmeldenummer: **84110889.7**

(22) Anmeldetag: **12.09.84**

(51) Int. Cl.⁴: **G 10 L 7/08**

(54) Verfahren zur Bestimmung von Sprachspektren für die automatische Spracherkennung und Sprachcodierung.

(30) Priorität: **29.09.83 DE 3335358**

(43) Veröffentlichungstag der Anmeldung:
**24.04.85 Patentblatt 85/17**

(45) Bekanntmachung des Hinweises auf die Patenterteilung:
**29.06.88 Patentblatt 88/26**

(84) Benannte Vertragsstaaten:
**AT DE FR GB IT**

(56) Entgegenhaltungen:
US-A-3 643 226

**ELECTRONICS AND COMMUNICATIONS IN JAPAN, Band 62-A, Nr. 12, Dezember 1979, Seiten 37-45, Scripta Publishing Co., Silver Spring, US; Y. MATSUYAMA: "Universal source coding and speech compression"**
**ICASSP 82 PROCEEDINGS OF THE IEEE INTERNATIONAL CONFERENCE ON ACOUSTICS, SPEECH AND SIGNAL PROCESSING, Paris, 3.-5. Mai 1982, Band 1, Seiten 593-596, IEEE, New York, US; R.M. GRAY et al.: "Full search and tree searched vector quantization of speech waveforms"**
**PROCEEDINGS OF THE 6TH INTERNATIONAL CONFERENCE ON PATTERN RECOGNITION, München, 19.-22. Oktober 1982, Band 2, Seiten 969-972, IEEE, New York, US; E. REUHKALA: "Pattern**

(73) Patentinhaber: **Siemens Aktiengesellschaft Berlin und München, Wittelsbacherplatz 2, D-8000 München 2 (DE)**

(72) Erfinder: **Höge, Harald, Dr. phil. nat., Hauptstrasse 19, D-8131 Unterbrunn (DE)**

(56) Entgegenhaltungen: (Fortsetzung)
**recognition for strings of discrete symbols"**

**Beschreibung**

Die vorliegende Erfindung betrifft ein Verfahren zur Bestimmung von Sprachspektren für automatische Spracherkennung und Sprachkodierung, bei dem ein Codebook-Baum, nämlich eine binär verzweigt orientierte und damit binär codiert adressierbare Anordnung von Codebook-Spektren, mit L Ebenen, die $2^L$ Spektren enthält, benutzt wird.

Sowohl bei hochwertigen Spracherkennungssystem als auch bei niedrigartigen Sprachcodiersystemen wird in einer Sprachanalysestufe das Kurzzeitspektrum des zu erkennenden Sprachsignals bestimmt. In einer Weiterverarbeitungsstufe kann die Struktur des Spektrums ermittelt werden. Hierbei hat sich die Methode der Vektorquantisierung als besonders günstig herausgestellt, durch welche Vektorquantisierung für Codiersysteme extrem geringe Datenraten erzielt werden können, vergl. A. Buzu et al: "Speech Coding based upon Vector Quantisation", IEEE Trans. ASSP, Vol. 28, pp. 562 - 574, 1980, und für Spracherkennungssystem eine sehr aufwandsgünstige Strukturanalyse des Spektrums vorgenommen werden kann.

Die Methode der Vektorquantisierung geht davon aus, daß die Vielfalt der Sprachspektren durch eine besonders ausgewählte Anzahl von Spektren, die in einem Codebook dargestellt werden, ohne einen wesentlichen Informationsverlust approximiert werden können.

Sowohl für eine gute Sprachqualität bei der Sprachcodierung als auch für eine Strukturanalyse bei der Spracherkennung sind große Codebooks mit ca. 1000 Spektren erforderlich.

Bei großen Codebooks tritt dann ein Problem auf, wenn in Echtzeit aus dem Codebook das zu den analysierten Spektren am besten passende Codebook-Spektrum zu bestimmen ist.

Aus der weiter oben genannten Druckschrift ist beispielsweise bekannt, daß sich Codebook-Spektren in einem binären Baum anordnen lassen. Die Bestimmung des ähnlichsten Codebook-Spektrums kann mit Hilfe einer Baumsuche wirkungsvoll durchgeführt werden. Bei einem derartigen binären Baum, dessen unterste Ebene $2^L$ Spektren umfaßt, sind bei der Baumsuche nur 2.L Versuche erforderlich. Bei einer Suche ohne Baumstruktur sind dagegen $2^L$ Vergleiche (vollständige Suche) durchzuführen. Die aufwandsgünstige Baumsuche hat jedoch den Nachteil, daß sie bei dem Vergleich nicht immer zu dem ähnlichsten Codebook-Spektrum, welches bei einer vollständigen Suche ermittelt worden wäre, führt.

Die Trefferrate, bei der das ähnlichste Spektrum gefunden wird, steigt, falls die Abarbeitung des Baumes nicht in der obersten Ebene (Ebene 1), sondern in einer tieferen Ebene (Ebene K, K < L) erfolgt. Bei diesem Vorgehen steigt jedoch die Anzahl der Vergleiche wieder an, da in der K-ten Ebene $2^K$ Vergleiche vorgenommen werden müssen.

Der vorliegenden Erfindung liegt die Aufgabe zugrunde, ein aufwandsgünstiges Verfahren zur Suche des jeweils passenden Codebook-Spektrums zu schaffen.

Zur Lösung der Aufgabe für die vorliegende Erfindung wird ein Verfahren zur Bestimmung von Sprachspektren für die automatische Spracherkennung und Sprachcodierung nach dem Oberbegriff des Patentanspruchs 1 vorgeschlagen, das durch die in den kennzeichnenden Teil des Patentanspruchs 1 angegebenen Merkmale charakterisiert ist.

Vorteilhafte Weiterbildungen der Erfindung sind durch die in den Unteransprüchen angegebenen Merkmale gekennzeichnet.

Im folgenden wird die Erfindung anhand mehrerer Figuren beschrieben.

Fig. 1 zeigt eine schematische Darstellung einer Systemanordnung zur Durchführung des eingangs genannten bekannten Verfahrens.

Fig. 2 zeigt eine schematische Darstellung einer sog. Baumstruktur eines Codebooks.

Fig. 3 zeigt ein schematisches Blockschaltbild für eine Anordnung zur Durchführung des erfindungsgemäßen Verfahrens.

Fig. 4 zeigt ein schematisches Diagramm, durch welches das Prinzip einer Codierung von Sprachspektren verdeutlicht wird.

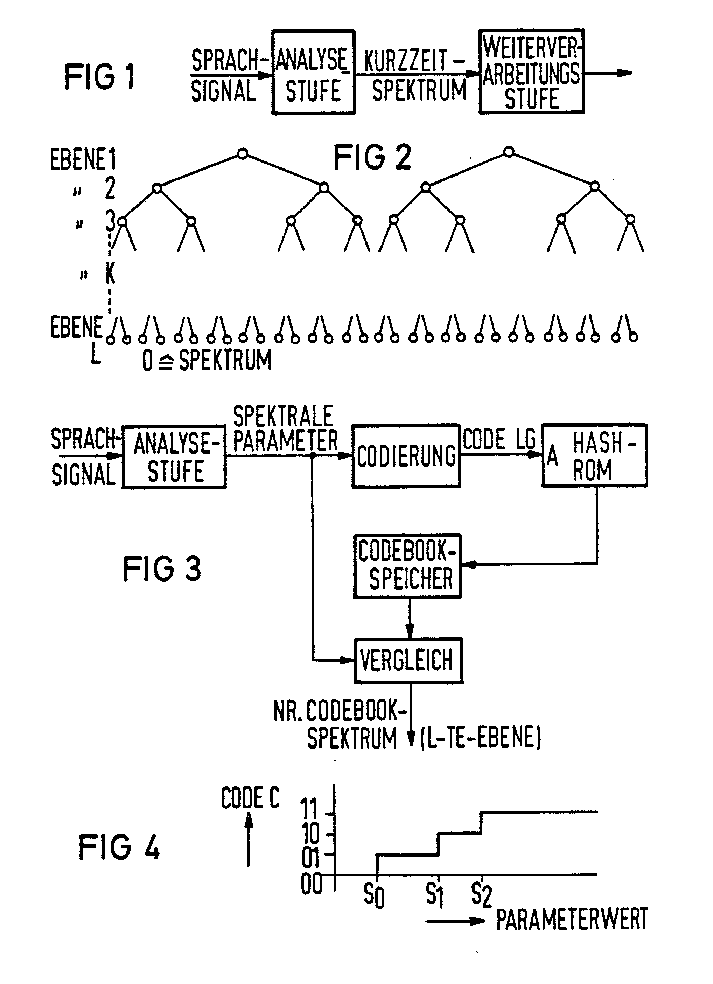

Wie bereits erläutert, zeigt Fig. 1 eine schematische Darstellung einer Systemanordnung zur Durchführung des eingangs genannten bekannten Verfahrens. In dieser Anordnung ist eine Analysestufe vorgesehen, der ein zu erkennendes Sprachsignal zugeführt wird. Die Analysestufe ermittelt ein sog. Kurzzeit-Spektrum und gibt die betreffenden Daten davon an eine Weiterverarbeitungsstufe ab, die aus diesen Daten den betreffenden Strukturparameter ermittelt und zur Weiterverarbeitung ausgibt.

Fig. 2 zeigt, wie bereits erläutert, eine schematische Darstellung einer sog. Baumstruktur eines Codebooks, wobei mehrere Ebenen 1 ... 3 ... K, L vorgesehen sind, wobei in jeweils jeder Ebene Plätze entsprechend der Zweierpotenz der Ordnungszahl der betreffenden Ebene für Spektren vorhanden sind.

Fig. 3 zeigt, wie bereits erläutert, ein schematisches Blockschaltbild für eine Anordnung zur Durchführung des erfindungsgemäßen Verfahrens. Gemäß dieser Anordnung wird zunächst in einer Analysestufe ein spektraler Parameter mit Hilfe eines Signalprozessors oder einer anderen geeigneten Hardware-Schaltung bestimmt. Als spektrales Parameter kommen zum Beispiel die Reflexionskoeffizienten bei der sog. LPC-Methode oder die Energiewerte von Filterbänken in Frage. Jeder der gewonnenen Parameter wird kodiert, vergl. Fig. 4, wobei jedem Parameterwert $P_i$ ein Code $C_i$ mit einer vorgegebenen Länge $L_i$ zugeordnet werden kann.

Die Gesamtheit der Codes $\{C_i\}$ wird zu einem Gesamtcode $C_g$ mit der Länge $L_g \Sigma L_i$ zusammengefaßt. Dieser Gesamtcode wirkt als Adressensignal auf einen Nur-Lesespeicher ROM. Dieser Nur-Lesespeicher ROM enthält als Inhalt die zu dem betreffenden Spektrum gehörende Nummer des Codebook-Spektrums der K-ten Ebene (Prinzip des sog. Hash-Coding). Falls aus dem Gesamtcode $L_g$ nicht eindeutig auf ein Codebook-Spektrum geschlossen werden kann, ist die Möglichkeit gegeben, daß das ROM mehrere mögliche Nummern für die Codebook-Spektren der K-ten Ebene zur Verfügung stellt.

Die Nummern der ausgelesenen Codebook-Spektren dienen als Zeiger des Codebook-Speichers, der den Baum von der K-ten Ebene ab enthält.

Damit wird ein Einstieg in die K-te Ebene des Baumes erreicht. Die endgültige Bestimmung des Codebook-Spektrums in der L-ten Ebene erfolgt in einer Vergleichseinheit mittels einer sog. Baumsuche. Die Vergleichseinheit kann aus einem Signalprozessor, vorzugsweise einem Mikroprozessor, oder einer geeigneten Hardware-Schaltung bestehen.

**Patentansprüche**

1. Verfahren zur Bestimmung von Sprachspektren für die automatische Spracherkennung und Sprachcodierung, bei dem ein Codebook-Baum, nämlich eine binär verzweigt orientierte und damit binär codiert adressierbare Anordnung von Codebook-Spektren, mit L Ebenen, die $2^L$ Spektren enthält, benutzt wird, dadurch gekennzeichnet, daß in einer Analysestufe (A), der ein zu analysierendes Sprachsignal zugeführt wird, zunächst vorzugsweise mit Hilfe eines Signalprozessors (S) der jeweils betreffende spektrale Parametersatz bestimmt wird, daß jeder gewonnene Parametersatz mit Parameterwerten $P_i$ in einer Codierungsstufe (C) binär codiert wird, wobei jedem Parameterwert $P_i$ ein Code $C_i$ zugeordnet wird, daß die Gesamtheit der zu bewertenden entstandenen Codes ($\{C_i\}$) zu einem Gesamtcode ($C_g$) zusammengefaßt wird, daß der Gesamtcode ($C_g$) als ein Adressierungssignal für einen Nur-Lesespeicher ROM, nämlich ein Hash-ROM (H), verwendet wird, wobei das Hash-ROM (H) als Speicherinhalt die zu dem erforderlichen Spektrum zugehörigen Nummern der Codebook-Spektren in einer K-ten Ebene des Codebook-Baumes enthält, daß die Nummern der Codebook-Spektren als Zeiger des Codebook-Speicherteils, der den Codebook-Baum von der K-ten Ebene ab enthält, benutzt werden und daß nachdem auf diese Weise ein Einstieg in die K-te Ebene des Codebook-Baumes ermöglicht worden ist, eine endgültige Bestimmung des Codebook-Spektrums in der L-ten Ebene des Codebook-Baumes mittels einer Vergleichseinheit (V) auf dem Wege einer Baumsuche durchgeführt wird.

2. Verfahren nach Anspruch 1, dadurch gekennzeichnet, daß als Parameter $P_i$ die

Reflexionskoeffizienten bei Verwendung des LPC-Verfahrens verwendet werden.

3. Verfahren nach Anspruch 1, dadurch gekennzeichnet, daß als spektrale Parameter $P_i$ die Energiewerte von benutzten Filterbänken verwendet werden.

4. Verfahren nach Anspruch 1, dadurch gekennzeichnet, daß in dem Hash-ROM (H) mehrere mögliche Nummern für die Codebook-Spektren der K-ten Ebene enthalten sind, die für den Fall bedarfsweise verwendet werden, daß aus dem Gesamtcode ($C_g$) nicht eindeutig auf ein Codebook-Spektrum geschlossen werden kann.

**Claims**

1. A method of determining speech spectra for automatic speech recognition and speech coding, wherein a codebook tree is used, namely an arrangement of codebook spectra which is orientated with binary branching and thus can be addressed in binary-coded fashion, with L levels, which contains $2^L$ spectra, characterised in that in an analysis stage (A) which is supplied with a speech signal which is to be analysed, firstly, preferably using a signal processor (S), the respective spectral parameter set is determined, that each obtained parameter set comprising parameter values $P_i$ is binary-coded in a coding stage (C) whereby each parameter value $P_i$ is assigned a code $C_i$, that all the codes ($\{C_i\}$) which have been formed and which are to be evaluated are combined to form an overall code ($C_g$), that the overall code ($C_g$) is used as addressing signal for a read-only store ROM, namely a Hash-ROM (H), where the store content of the Hash-ROM (H) comprises the numbers, assigned to the required spectrum, of the codebook spectra in a K-th level of the codebook tree, that the numbers of the codebook spectra are used as an indicator of the codebook store section which contains the codebook tree from the K-th level, and that when entering into the K-th level of the codebook tree has been facilitated in this way, a final determination of the codebook spectrum in the L-th level of the codebook tree is carried out by means of a comparator unit (V) in the form of a tree search.

2. A method as claimed in claim 1, characterised in that when the LPC-method is used, the reflection coefficients are used as parameters $P_i$.

3. A method as claimed in claim 1, characterised in that the energy values of employed filter banks are used as spectral parameters $P_i$.

4. A method as claimed in claim 1, characterised in that the Hash-ROM (H) contains a plurality of possible numbers for the codebook spectra of the K-th level which are used as and when required in the event that a codebook spectrum cannot be clearly determined from the overall code ($C_g$).

**Revendications**

1. Procédé pour déterminer des spectres de parole pour l'identification et le codage automatiques de la parole, selon lequel on utilise un arbre de Codebook, à savoir un ensemble de spectres du Codebook, orienté selon une ramification binaire et par conséquent adressable d'une manière codée en binaire, et comportant L plans et contenant $2^L$ spectres, caractérisé par le fait que dans un étage d'analyse (A), auquel un signal de parole devant être analysé est envoyé, on détermine tout d'abord, de préférence à l'aide d'un processeur (S) de traitement de signaux, le jeu spectral respectivement considéré de paramètres, qu'on code en binaire chaque jeu de paramètres obtenu, avec des valeurs de paramètres $P_i$, dans un étage de codage (C), auquel cas un code $C_i$ est associé a chaque valeur de paramètre $P_1$, qu'on réunit la totalité des codes ($\{C_i\}$), qui apparaissent et doivent être pondérés, pour former un code global ($C_g$) qu'on utilise le code global ($C_g$) en tant que signal d'adressage pour une mémoire morte (ROM), à savoir ce qu'on appelle une mémoire Hash-ROM (H), cette mémoire Hash-ROM ayant comme contenu les numéros, associés au spectre nécessaire, des spectres du Codebook situés dans un K-ème plan de l'arbre du Codebook, qu'on utilise des numéros des spectres du Codebook comme vecteurs de la partie de la mémoire du Codebook, qui contient l'arbre du Codebook à partir du K-ème plan, et que, dès que l'entrée dans le K-ème plan de l'arbre du Codebook est devenue possible de cette manière, on exécute une détermination définitive du spectre du Codebook dans le L-ème plan de l'arbre du Codebook, à l'aide d'une unité de comparaison (V) lors d'une recherche conformément à un arbre.

2. Procédé suivant la revendication 1, caractérisé par le fait qu'on utilise comme paramètres $P_i$, les coefficients de réflexion dans le cas de la mise en oeuvre du procédé LPC.

3. Procédé suivant la revendication 1, caractérisé par le fait qu'on utilise comme paramètres spectraux $P_i$ les valeurs d'énergie de blocs de filtres utilisés.

4. Procédé suivant la revendication 1, caractérisé par le fait que la mémoire Hash-ROM (H) contient plusieurs numéros possibles pour les spectres du Codebook du K-ème plan, qu'on utilise éventuellement dans le cas où l'on ne peut pas déterminer de façon nette un spectre du Codebook, sur la base du code global ($C_g$).

FIG 1

FIG 2

FIG 3

FIG 4